Europäisches Patentamt

European Patent Office

Office européen des brevets

(19)

(11) **EP 1 396 929 A2**

(12) **EUROPEAN PATENT APPLICATION**

(43) Date of publication:
**10.03.2004 Bulletin 2004/11**

(51) Int Cl.⁷: **H02P 7/05**

(21) Application number: **03255487.5**

(22) Date of filing: **03.09.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventors:<br>• **Tankard, Michael Paul**<br>  **Harrogate HG1 4HS (GB)**<br>• **Brown, Andrew Duncan**<br>  **Leeds LS6 2LZ (GB)** |
| (30) Priority: **05.09.2002 GB 0220673** | (74) Representative: **Hibbert, Juliet Jane Grace et al**<br>**Kilburn & Strode,**<br>**20 Red Lion Street**<br>**London WC1R 4PJ (GB)** |
| (71) Applicant: **SWITCHED RELUCTANCE DRIVES LIMITED**<br>**Harrogate, North Yorkshire HG3 1PR (GB)** | |

(54) **Measurement of the rate of change of current in switched reluctance machines**

(57) A coil is fabricated as two or more tracks 42, 43 of a printed circuit board and arranged close to a conductor 50 to measure the rate of change of current in the conductor. Each turn of the coil is displaced from its neighbouring turn in a direction parallel to the direction of the conductor. The output from the coil may be used to provide a detection signal for a position detection scheme in a switched reluctance drive.

Fig 5

Printed by Jouve, 75001 PARIS (FR)

EP 1 396 929 A2

**Description**

This invention relates to the detection of a point on a current waveform where the gradient of the current changes sign. It is particularly applicable to the control of switched reluctance machines.

The control and operation of switched reluctance machines generally are described in the paper "The Characteristics, Design and Applications of Switched Reluctance Motors and Drives" by J M Stephenson and R J Blake delivered at the PCIM'93 Conference and Exhibition held in Nurnberg, Germany, 21-24 June 1993 and incorporated herein by reference. In that paper the "chopping" and "single-pulse" modes of energisation of switched reluctance machines are described for operation of the machine at low and high speeds respectively.

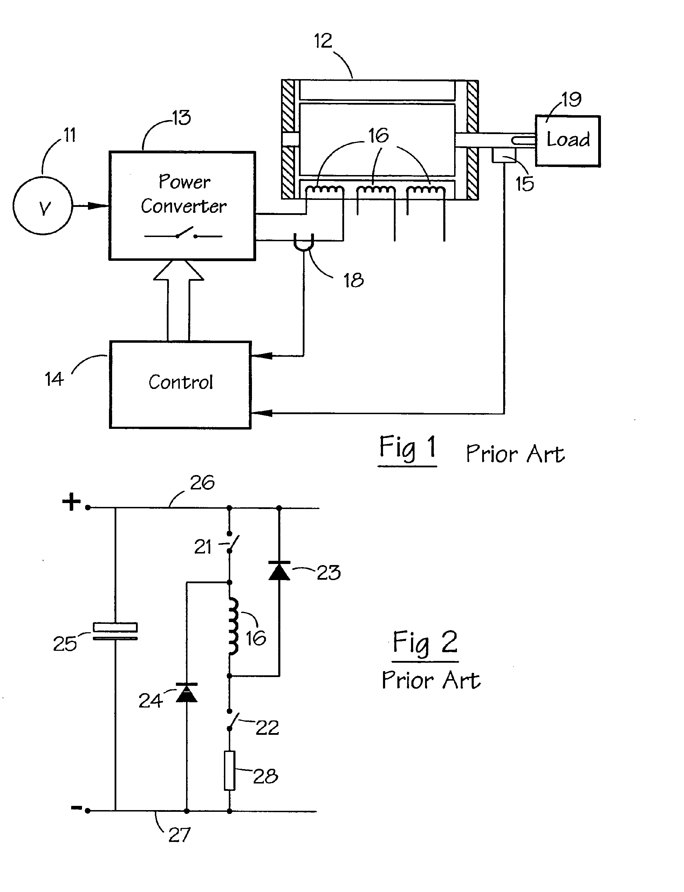

A typical prior art drive is shown schematically in Figure 1. This includes a DC power supply 11 that can be either a battery or rectified and filtered AC mains. The DC voltage provided by the power supply 11 is switched across phase windings 16 of the motor 12 by a power converter 13 under the control of the electronic control unit 14. Some form of current transducer 18 is normally provided to give phase current feedback. One of the many known converter topologies is shown in Figure 2, where a resistor 28 is connected in series with the lower switch 22 to provide a current feedback signal.

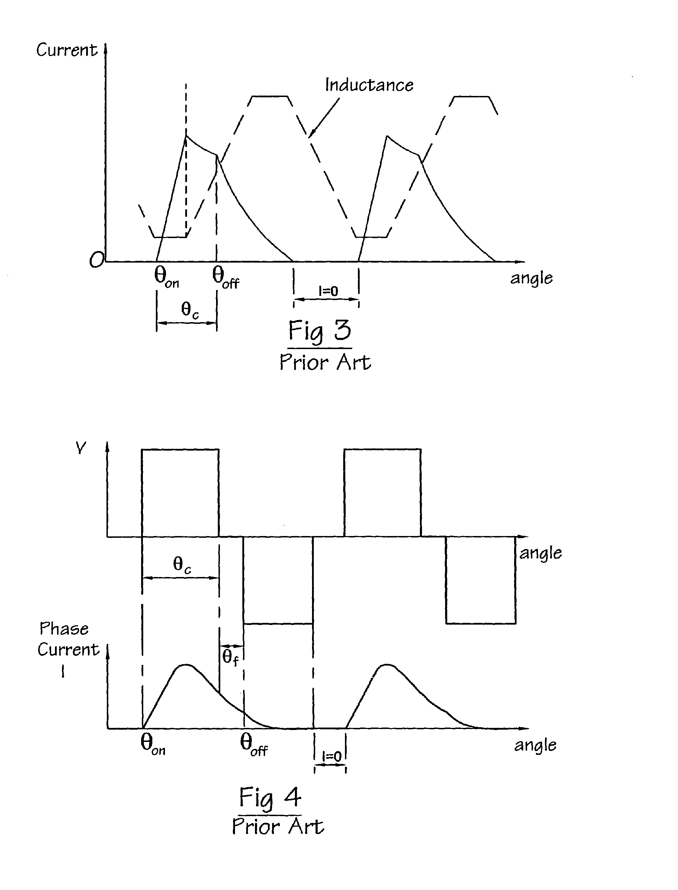

At low speeds, switched reluctance systems generally operate in a current-controlled or chopping mode, while at higher speeds they typically operate in the single-pulse mode of energisation. This mode is illustrated in Figure 3 in which the linearised current and inductance waveforms are shown over a phase inductance period. The current rises when the voltage is applied to the phase winding at the switch-on angle $\theta_{on}$, reaches a peak and then rolls over as the rotor poles begin to overlap the stator poles and the inductance rises. The current is limited naturally by the back emf of the circuit. The voltage is reversed at the switch-off angle $\theta_{off}$, after a conduction angle $\theta_c$, and the current falls at a faster rate as energy is returned to the supply and ceases when it reaches zero. There is then a period of zero current before the cycle begins again. In practice, the inductance waveform has rounded corners due to flux fringing in the air, and this leads to corresponding rounding of the current waveform, as shown in Figure 4.

An alternative switching strategy uses freewheeling for a period before $\theta_{off}$, whereby the switching circuit allows the current to re-circulate in the phase winding without an applied voltage. Figure 4 illustrates this technique and the period of zero applied voltage during freewheeling is clearly shown. Again, the current falls to zero for a time before the cycle repeats.

While motoring operation has been illustrated in the above discussions, it is well-known that the machines operate equally well in the generating mode, in which the current waveforms are generally mirror images in time of the motoring waveforms.

The performance of a switched reluctance machine depends, in part, on the accurate timing of phase energisation with respect to rotor position. Detection of rotor position is conventionally achieved by using a position transducer 15, shown schematically in Figure 1, such as a rotating toothed disk mounted on the machine rotor, which co-operates with an optical or magnetic sensor mounted on the stator. A pulse train indicative of rotor position relative to the stator is generated and supplied to control circuitry, allowing accurate phase energisation.

Alternative methods of position detection include the so-called "sensorless" methods, in which the position is deduced from measurements of another parameter of the machine. Such methods have the benefit that no dedicated position sensor is required on the machine, leading to reduced cost and increased reliability. A summary of many known sensorless methods is given in "Review of sensorless control methods in switched reluctance motor drives", by Fahimi *et al,* IAS2000, Thirty-fifth Annual Meeting and World Conference on Industrial Applications of Electrical Energy, 8-12 October 2000, Rome, Italy, Vol 3, pp 1850 - 1857. Among the known methods are those which make use of the feature in an unsaturated phase current waveform where the peak current coincides with the onset of overlap between the rotor and stator poles, as shown in Figure 3. These techniques are discussed in some detail in the paper "A New Indirect Rotor Position Detection Method For Switched Reluctance Drives", by Kjaer *et al,* Proc International Conference on Electrical Machines, 5-8 September 1994, Paris, Vol 2, pp 555 - 560, incorporated herein by reference. A particular method of determining the onset of pole overlap is disclosed in EPA 1109309 (Moriarty), incorporated herein by reference.

All of these techniques require an accurate knowledge of the phase current, especially if the derivative of the current is required, since the process of differentiation automatically emphasises any errors. Accurate current sensing can be performed by Hall-effect current transducers, which also provide electrical isolation from the phase current, but these are costly and, in low-power drives, take up a considerable amount of space. In low-cost applications, a current sense resistor is often used, as shown in Figure 2, but these do not provide isolation and, in low-voltage applications, the extra voltage drop across the resistor often produces an unacceptable degradation in performance.

The Rogowski coil has enjoyed a return to use in recent years, and a recent paper "Voltage Profiles and Closures on Rogowski Coils" by Viana *et al,* Proc IEE, Electric Power Applications, Vol 149 No 3, May 2002, pp 223-227, details recent studies on the accuracy of the system. The Rogowski coil measures the field surrounding a conductor and gives a voltage proportional to the rate of change of the sensed current. This voltage is then integrated by a specially designed circuit to give a measure of the current. The design of the integrator and the calibration of the system are by no means trivial. While such systems, when well-designed, can give high accuracy over a wide bandwidth, they are generally regarded as high-cost laboratory tools rather than as suitable for low-cost, mass-produced applications. Attempts have been made to produce cheaper versions, without sacrificing too much accuracy, such as those discussed in US 5414400 (Gris), incorporated herein by reference, but the need to place the conductor through the printed circuit board can lead to significant assembly problems.

US Patent No. 6380727 discloses a current sensor using Printed Circuit Board (PCB) trace-loops. Both the current sensor and the conductor are provided as PCB copper traces on a PCB board. The current flow in the conductor is orthogonal to the axis of the coil.

There is therefore a need for a low-cost current measuring system for a switched reluctance machine which can monitor the rate of change of phase current and detect when the roll-over of the current occurs.

In accordance with the present invention there is provided a rate of change of current sensor comprising a coil for coupling the flux from a conductor in which the rate of change of current is to be sensed, the coil comprising a plurality of turns, each turn being a track on a printed circuit board, each turn being displaced from its neighbouring turn in a direction parallel to the direction of the conductor.

The flux linkage between the conductor and the coil is thereby increased.

Preferably the printed circuit board has at least a first layer and a second layer, each turn comprising a first part of the turn on the first layer and a second part of the turn on the second layer, the first and second parts of the turn being connected by a via extending through the printed circuit board.

The turns may be of any suitable shape e.g. rectangular, circular or hexagonal. Preferably each turn of the coil is of the same dimension as the other turns.

Means may be provided on the printed circuit board to hold the conductor in place relative to the coil. Alternatively the conductor may be formed on a layer of the printed circuit board or may comprise a layer of the printed circuit board. The conductor may be a split conductor having at least two limbs each of which runs close to the vias of either side of the coil.

In a preferred embodiment, two coils are provided on the printed circuit board with the conductor extending between the two coils.

In a second aspect of the invention there is provided a switched reluctance drive including a motor having a rotor defining a plurality of rotor poles, a stator defining a plurality of stator poles, and at least one phase winding for exciting two or more of the poles, and a sensor according to the invention, the sensor being connected to sense the rate of change of current in the phase winding.

Preferably the output of the sensor is fed to a circuit which detects the point at which the rate of change of current crosses zero. The output of the sensor may be used to provide rotor position information.

The present invention is defined in the accompanying independent claims. Some preferred features are recited in the dependent claims.

The invention can be put into practice in a number of ways, some of which will now be described by way of example and with reference to the accompanying drawings in which:

Figure 1 shows a typical prior art switched reluctance drive;
Figure 2 shows a known topology of one phase of the converter of Figure 1;
Figure 3 shows an ideal current waveform in single-pulse control;
Figure 4 shows a typical current waveform in single-pulse control using freewheeling;
Figure 5 shows a coil according to one aspect of the invention;
Figure 6 shows a coil according to another aspect of the invention;
Figure 7 shows a coil according to a yet further aspect of the invention;
Figure 8 shows a typical output waveform from a coil; and
Figure 9 shows an exemplary zero crossing detection circuit.

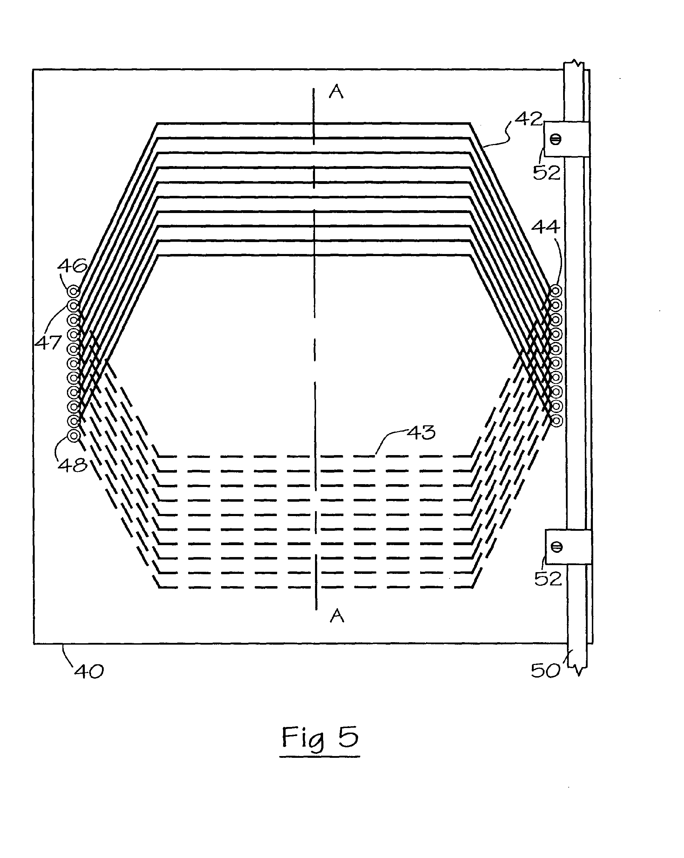

One embodiment of the invention is shown in Figure 5, where a conductor 50 carries a current to be sensed. In the field of switched reluctance machines, typically this conductor leads to the phase winding of the switched reluctance machine. The conductor is arranged parallel to a printed circuit board (PCB) and may be held in place by retaining means 52 which can take the form of features on the PCB, clips or other fasteners as commonly used. The PCB may be dedicated to current detection, as shown in Figure 5, or it may carry some or all of the control system and power converter to control an electrical machine. For example, it may contain some or all of the items 13 and 14 to control a switched reluctance machine as shown in Figure 1.

A planar coil is fabricated on the PCB by laying out conductive tracks, typically of copper, on the PCB, as is known in the art. Figure 5 shows the coil laid out on the upper (solid lines) and lower (dashed lines) sides of the PCB, the sides of each turn of the coil being connected by vias in the usual way. The coil begins at via 46 and the track 42 constitutes the first part of the first turn. This part is connected to the second part 43 of the first turn, on the other side of the board, by via 44. The second part of the first turn is connected to the first part of the next turn by via 47 and the coil is continued in this fashion until the second part of the last turn is terminated at via 48. The output voltage of the coil appears across vias 46 and 48.

The number of turns in the coil is a variable influenced by, *inter alia*, the size of the current to be sensed, the available area on the board and the accuracy required. The current i in conductor 50 produces a voltage in the coil given by:

$$V_c = A \, di/dt \qquad (1)$$

where A is a constant whose value depends in a complex fashion on the geometry of the coil, the number of turns and the disposition of the conductor to the coil. It may best be determined empirically. In Figure 5, the conductor is shown close to the vias at one side of the coil. If the conductor is moved away from the coil, the value of A, and hence $V_c$, falls, since the coil links less of the field surrounding the coil. If the conductor is moved towards the centre of the coil, the value of A will initially rise a little, then falls as the field to the right of the conductor begins to link the coil and cancels the original field. When the conductor is central to the coil the output falls virtually to zero.

As can be seen in Figure 5, each turn of the coil is displaced from its neighbouring turn in a direction which, in use, is parallel to the direction of the conductor and in particular the direction of the current flow in the conductor. Thus the second turn of the coil is displaced along the line A-A from the first turn, the third turn of the coil is displaced along the line A-A from the second turn and so on for the remainder of the turns of the coil. This arrangement of the coil increases the flux linkage between the conductor 50 and the coil. This can also be viewed as the conductor being arranged parallel to a line formed by the axes of the turns of the coil. In Figure 5 the axis of each turn is orthogonal to the page.

Figure 5 shows a hexagonal shaped coil, which is convenient for PCB manufacture, though other shapes are possible, e.g. rectangular or circular. Alternatively, the coil may be fabricated by depositing tracks on three or more layers and suitably interconnecting them. The conductor 50 can be constituted by a track or tracks on one of the layers of the PCB.

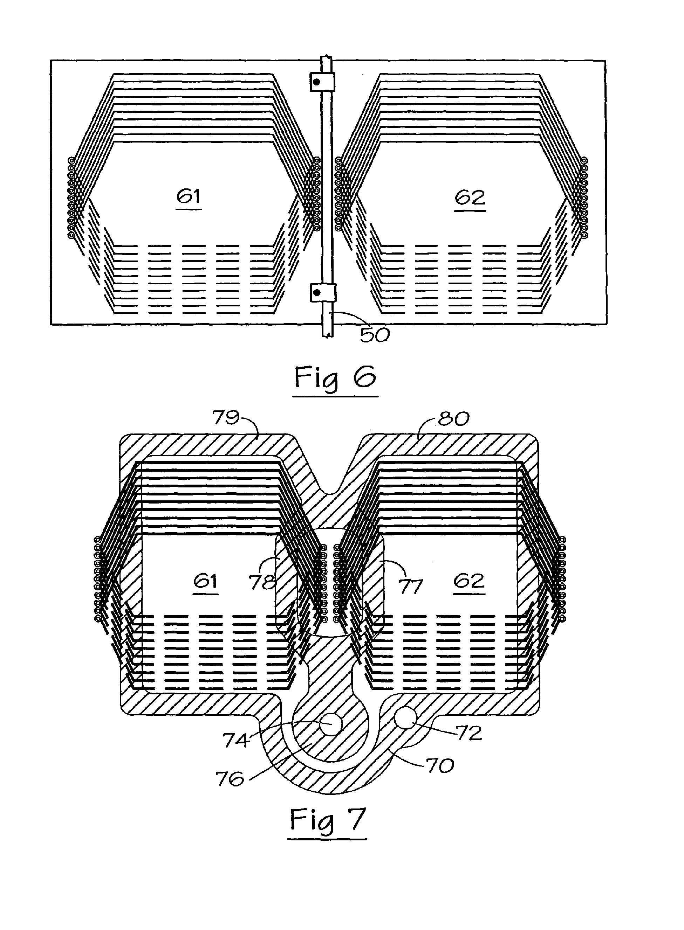

Another embodiment is shown in Figure 6, where the conductor 50 is placed between two coils 61, 62 , each fabricated in a similar way to the coil of Figure 5, so that, by appropriately connecting the two coils, the sensitivity of the output is enhanced.

A yet further embodiment is shown in Figure 7, where two coils and a split conductor are laid out to maximise the sensitivity of the system. The conductor is formed by a track which may be provided on one or more layers of the PCB. This arrangement can conveniently be laid out with the coil sides on the top and bottom layers as before and the conductor track on a middle layer. The conductor track has pads or terminals 72, 74 to allow connection to an external circuit. If the current flows in at, say, 74, it flows up limb 76 then splits into limbs 77, 78. This split avoids the vias connecting the coil sides. The current then flows along limbs 79, 80 and returns to the bottom limb 70, to exit the circuit at 72. This arrangement allows each coil 61, 62 to be influenced by the current from two limbs, thus maximising the sensitivity.

Note that the power conductor track in Figure 7 is laid out for clarity and in practice limbs 77,78 could run closer to the coil side connections and the outer limbs could run closer to the outer connections.

The conductor 50 may form part of a bus bar that connects with the switch 22 and the phase winding 16. Alternatively switch 22 may also be provided on the PCB and connected to the coil and the phase winding by means of the conductor 50. Referring to Figure 7, the phase winding may be connected directly to the terminals 72, 74.

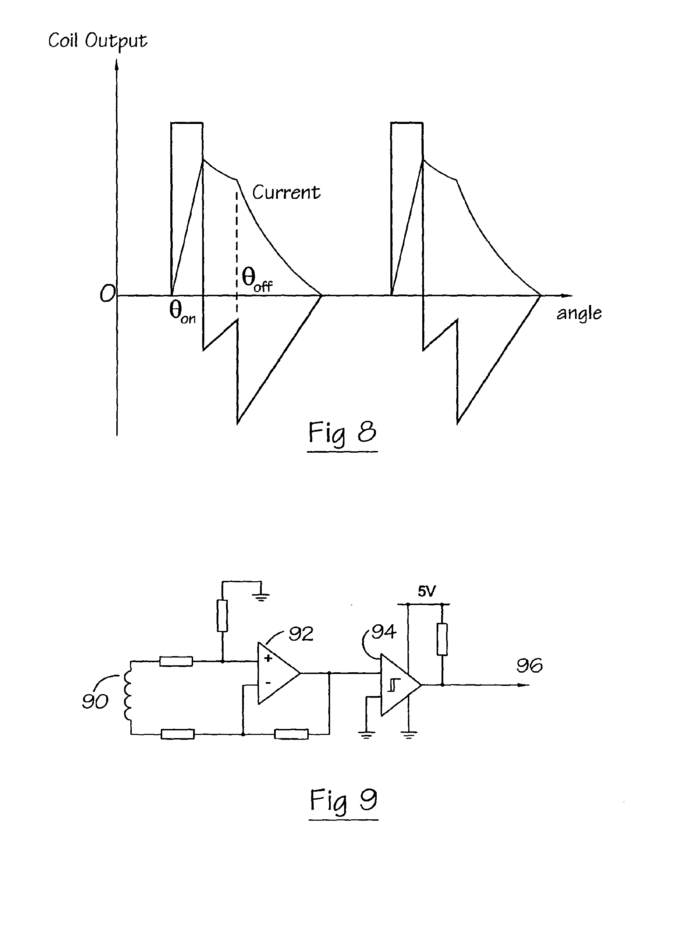

The output from a coil such as shown in Figures 5, 6 or 7 will depend on the shape of the current waveform. Figure 8 shows the type of waveform produced by the current of Figure 3, in accordance with Equation 1. The output from the coil is used to provide a detection signal for a position detection scheme in a switched reluctance drive. In order to use the coil output to detect the point of current roll-over, the point where the coil output crosses zero must be detected.

This can be done in any convenient way, as well understood by those skilled in the art. An exemplary circuit is given in Figure 9. The coil 90 is connected to a differential amplifier 92 which supplies an output to the Schmitt comparator 94. The output 96 can be used to drive the interrupt of a microprocessor in known fashion. The microprocessor can then be programmed with a sensorless position detection algorithm, e.g. as described in EPA 1109309.

Note that it is not necessary to know the exact magnitude of the coil output (i.e. to know the value of the constant A in Equation 1) since it is the position of the zero crossing that is important, not the magnitude of the waveform. The output only needs to be large enough to drive the detection circuit reliably.

The skilled person will appreciate that variations of the disclosed arrangements are possible without departing from the invention. Accordingly, the above description of several embodiments is made by way of example and not for the purposes of limitation. It will be clear to the skilled person that minor modifications can be made without significant changes to the operation described above. The present invention is intended to be limited only by the scope of the following.

**Claims**

1. A rate of change of current sensor comprising a coil for coupling the flux from a conductor in which the rate of change of current is to be sensed, the coil comprising a plurality of turns, each turn being a track on a printed circuit board, each turn being displaced from its neighbouring turn in a direction parallel to the direction of the conductor.

2. A sensor according to claim 1 wherein the printed circuit board has at least a first layer and a second layer, each turn comprising a first part of the turn on the first layer and a second part of the turn on the second layer, the first and second parts of the turn being connected by a via extending through the printed circuit board.

3. A sensor according to claim 1 or 2 wherein the turns are rectangular, circular or hexagonal in shape.

4. A sensor according to any of claims 1, 2 or 3 wherein a feature is provided on the printed circuit board to hold the conductor in place relative to the coil.

5. A sensor according to any preceding claim wherein the conductor is formed on or comprises a layer of the printed circuit board.

6. A sensor according to any of claims 1 to 5 wherein the conductor is a split conductor having at least two limbs each of which runs close to the vias of either side of the coil.

7. A sensor according to any of claims 1 to 5 wherein two coils are provided on the printed circuit board, the conductor extending between the two coils.

8. A sensor according to any preceding claim wherein each turn of the coil is of the same dimension as the other turns.

9. A switched reluctance drive including a motor having a rotor defining a plurality of rotor poles, a stator defining a plurality of stator poles, and at least one phase winding for exciting two or more of the poles, and a sensor as claimed in any preceding claim connected to sense the rate of change of current in at least one phase winding.

10. A switched reluctance drive as claimed in claim 9 wherein the output of the sensor is fed to a circuit which detects the point at which the rate of change of current crosses zero.

11. A switched reluctance drive as claimed in claim 10 wherein the output of the sensor is used to provide rotor position information.

Fig 1   Prior Art

Fig 2
Prior Art

Current

Inductance

$O$

$\theta_{on}$ $\theta_{off}$ angle

I=0

$\theta_c$

Fig 3
Prior Art

V

angle

$\theta_c$

Phase
Current
I

$\theta_f$

$\theta_{on}$ $\theta_{off}$ angle

I=0

Fig 4
Prior Art

Fig 5

Fig 6

Fig 7

Fig 8

Fig 9